(19) **Europäisches Patentamt European Patent Office Office européen des brevets**

(11) **EP 4 723 212 A1**

(12) **EUROPEAN PATENT APPLICATION**
published in accordance with Art. 153(4) EPC

(43) Date of publication:
08.04.2026 Bulletin 2026/15

(21) Application number: 24815795.0

(22) Date of filing: 23.05.2024

(51) International Patent Classification (IPC):
$H01M\ 4/36^{(2006.01)}$  $H01M\ 4/525^{(2010.01)}$
$C01G\ 53/00^{(2025.01)}$  $H01M\ 10/052^{(2010.01)}$
$C30B\ 29/22^{(2006.01)}$  $H01M\ 4/02^{(2006.01)}$

(52) Cooperative Patent Classification (CPC):
Y02E 60/10

(86) International application number:
PCT/KR2024/007029

(87) International publication number:
WO 2024/248419 (05.12.2024 Gazette 2024/49)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 31.05.2023 KR 20230070019

(71) Applicant: Posco Future M Co., Ltd.
Pohang-si, Gyeongsangbuk-do 37918 (KR)

(72) Inventors:
• PARK, Jeonghyeon
Sejong 30002 (KR)

• LIM, Seokjae
Gumi-si, Gyeongsangbuk-do 39171 (KR)
• SEO, Sunghwa
Sejong 30002 (KR)
• KIM, Seong In
Sejong 30002 (KR)
• KIM, Jaehan
Gumi-si, Gyeongsangbuk-do 39171 (KR)
• CHOI, Kwonyoung
Sejong 30002 (KR)

(74) Representative: Meissner Bolte Partnerschaft mbB
Patentanwälte Rechtsanwälte
Postfach 86 06 24
81633 München (DE)

(54) **CATHODE ACTIVE MATERIAL FOR LITHIUM SECONDARY BATTERY, MANUFACTURING METHOD THEREFOR, AND LITHIUM SECONDARY BATTERY COMPRISING SAME**

(57)  The present invention relates to a positive electrode active material for a lithium secondary battery, which is in a single-particle form and comprises a nickel-containing lithium transition metal oxide and a coating layer containing Al and W disposed on a surface of the lithium transition metal oxide, wherein a total content of the Al and W is from 2,000 ppm to 6,000 ppm based on the total weight of the positive electrode active material.

EP 4 723 212 A1

**Description**

[Technical Field]

The present invention relates to a positive electrode active material for a lithium secondary battery, a method for manufacturing the same, and a lithium secondary battery including the same. More specifically, the present invention relates to a positive electrode active material for a lithium secondary battery in a single-particle form, a method for manufacturing the same, and a lithium secondary battery including the same.

[Background Art]

A lithium secondary battery generates electrical energy through oxidation and reduction reactions that occur when lithium ions are intercalated into and deintercalated from active materials constituting a positive electrode and a negative electrode, while an organic or polymer electrolyte is filled between the positive and negative electrodes.

As the positive electrode active material of lithium secondary batteries, lithium cobalt oxide ($LiCoO_2$), lithium nickel oxide ($LiNiO_2$), lithium manganese oxides (such as $LiMnO_2$ or $LiMn_2O_4$), and lithium iron phosphate compounds ($LiFePO_4$) have been used. Among these, lithium cobalt oxide ($LiCoO_2$) has been widely employed as a high-voltage positive electrode active material because it exhibits a high operating voltage and excellent capacity characteristics. However, due to the rising price and unstable supply of cobalt (Co), its large-scale application as a power source for fields such as electric vehicles has become limited, thereby creating the need for alternative positive electrode active materials.

Accordingly, lithium composite transition metal oxides in which a portion of cobalt (Co) is substituted with nickel (Ni) and manganese (Mn), referred to as nickel-cobalt-manganese-based lithium composite transition metal oxides (hereinafter, simply referred to as "NCM-based lithium composite transition metal oxides"), have been developed. However, conventional NCM-based lithium composite transition metal oxides generally exist in the form of secondary particles in which primary particles are agglomerated, and thus have a large specific surface area, low particle strength, and a high content of lithium by-products. Consequently, they exhibit excessive gas generation during cell operation and suffer from degraded lifespan and stability.

To overcome these issues, development efforts have been directed toward single-particle-type positive electrode active materials rather than conventional secondary-particle-type materials. Such single-particle-type positive electrode active materials exhibit smaller specific surface areas and excellent particle strength, thereby providing improved lifespan and stability. However, since the crystallite size and the average particle size of primary particles are relatively large compared to those of secondary particles, such single-particle-type materials tend to exhibit degraded capacity characteristics.

[Detailed Description of the Invention]

[Technical Problem]

Accordingly, one object of the present invention is to provide a single-particle-type positive electrode active material that exhibits both excellent capacity characteristics and superior high-temperature cycle life characteristics, as well as a method for manufacturing the same and a lithium secondary battery including the same.

[Technical Solution]

According to one embodiment of the present invention, there is provided a positive electrode active material for a lithium secondary battery, which is in a single-particle form and comprises a nickel-containing lithium transition metal oxide and a coating layer containing Al and W disposed on a surface of the lithium transition metal oxide, wherein a total content of the Al and W is from 2,000 ppm to 6,000 ppm based on the total weight of the positive electrode active material.

A ratio (Al/(Al+W)) of the content of Al to the total content of Al and W may be from 0.28 to 0.7.

The positive electrode active material for a lithium secondary battery may have a nickel content of 50 mol% to 70 mol% based on the total moles of transition metals.

The positive electrode active material for a lithium secondary battery may have a cobalt content of 5 mol% to 20 mol% based on the total moles of transition metals.

The positive electrode active material for a lithium secondary battery may have a manganese content of 10 mol% to 40 mol% based on the total moles of transition metals.

A cation mixing ratio of nickel cations in a lithium layer of the lithium transition metal oxide may be 2.8% or less.

The positive electrode active material for a lithium secondary battery may have a residual lithium content of 3,000 ppm or less.

The positive electrode active material for a lithium secondary battery may have a compression density of 2.2 g/cc or higher.

The lithium transition metal oxide may be represented by the following Chemical Formula 1:

[Chemical Formula 1]       $Li_a[Ni_xCo_\gamma MnzM_{1w1}]O_2$

wherein $0.8 \leq a \leq 1.2$, $0.5 \leq x \leq 0.7$, $0.05 \leq y \leq 0.2$, $0.1 \leq z \leq 0.4$, $0 < w_1 \leq 0.1$, and $x + y + z + w_1 = 1$, and $M_1$ is one or more selected from Zr, Y, B, Al, Mg, Ti, Nb, W, Sc, Si, V, Fe, Y, Mo, Ce, Hf, Ta, La, and Sr.

According to another embodiment of the present invention, there is provided a method for manufacturing a positive electrode active material for a lithium secondary battery, comprising: preparing a nickel-containing transition metal precursor; mixing the transition metal precursor and a lithium raw material, followed by calcination at a temperature of 900°C to 960°C and pulverization to form a single-particle lithium transition metal oxide; and mixing the lithium transition metal oxide with an Al raw material and a W raw material, followed by heat treatment at a temperature of 400°C to 500°C to form a coating layer.

The Al raw material may be $Al_2O_3$, $Al(OH)_3$, $Al_2(SO_3)_3$, or a combination thereof.

The W raw material may be $WO_2$, $WO_3$, $WS_2$, $WS_3$, or a combination thereof.

The Al raw material and the W raw material may be oxides.

The heat treatment may be performed for 5 to 8 hours.

The heat treatment may be performed in an air atmosphere.

Another embodiment of the present invention provides a positive electrode for a lithium secondary battery comprising the above-described positive electrode active material.

Still another embodiment of the present invention provides a lithium secondary battery comprising the above-described positive electrode for a lithium secondary battery.

[Advantageous Effects]

The positive electrode active material for a lithium secondary battery according to one embodiment of the present invention is in a single-particle form, and by appropriately controlling the composition and components of the coating layer, both excellent capacity characteristics and superior high-temperature cycle life characteristics can be simultaneously achieved.

[Modes for Carrying Out the Invention]

The terms first, second, and third, etc. are used to describe various parts, components, regions, layers, and/or sections, but are not limited thereto. These terms are used only to distinguish one part, component, region, layer, or section from another. Accordingly, a first part, component, region, layer, or section described below may be referred to as a second part, component, region, layer, or section within the scope of the present invention.

The technical terms used herein are merely for describing particular embodiments and are not intended to limit the present invention. The singular forms used herein are intended to include the plural forms as well, unless the context clearly indicates otherwise. As used in the specification, the term "comprise" specifies the presence of stated features, regions, integers, steps, operations, elements, and/or components, but does not preclude the presence or addition of one or more other features, regions, integers, steps, operations, elements, and/or components.

When a part is referred to as being "on" or "over" another part, it may be directly on or over the other part, or intervening parts may be present therebetween. In contrast, when a part is referred to as being "directly on" another part, there are no intervening parts therebetween.

Unless otherwise defined, all terms used herein, including technical and scientific terms, have the same meaning as commonly understood by one of ordinary skill in the art to which the present invention pertains. Terms defined in commonly used dictionaries are to be interpreted as having meanings consistent with the relevant technical literature and the present disclosure, and are not to be interpreted in an idealized or overly formal sense unless expressly defined herein.

Unless otherwise specified, "%" means weight percent, and 1 ppm means 0.0001 wt%.

In this specification, the expression "combinations thereof" described in a Markush-type expression means one or more mixtures or combinations selected from the group consisting of the components recited in the Markush-type expression, and indicates inclusion of any one or more selected from the group.

In this specification, the term "single particle" is used to distinguish from conventional positive electrode active material particles of the secondary-particle type formed by agglomeration of several tens to several hundreds of primary particles. The term "single particle" encompasses a single particle consisting of one primary particle and an agglomerate particle consisting of thirty (30) or fewer primary particles. The term "secondary particle" refers to an agglomerate-i.e., a secondary structure-in which several tens to several hundreds of primary particles are agglomerated with one another through physical or chemical bonding of the primary particles without an intentional agglomeration or assembly process applied to the primary particles.

In this specification, the term "primary particle" means the smallest particle unit distinguishable as a single mass when a cross-section of the positive electrode active material is observed with a scanning electron microscope (SEM), and it may consist of a single crystallite or a plurality of crystallites.

In this specification, the term "crystallite" means a distinct region within a primary particle in which atoms form a lattice structure of a certain orientation.

Hereinafter, embodiments of the present invention will be described in detail to enable those skilled in the art to which the present invention pertains to readily carry out the invention. However, the present invention may be implemented in various different forms and is not limited to the embodiments set forth herein.

**1. Positive Electrode Active Material**

A positive electrode active material for a lithium secondary battery according to one embodiment of the present invention comprises a nickel-containing lithium transition metal oxide and a coating layer containing Al and W disposed on a surface of the lithium transition metal oxide, and has a single-particle form.

The positive electrode active material for a lithium secondary battery according to an embodiment of the present invention, being in a single-particle form and including a coating layer containing A1 and W, can simultaneously improve both the capacity and cycle life characteristics of the battery.

In particular, a total content of Al and W may be from 2,000 ppm to 6,000 ppm, and more specifically from 2,100 ppm to 5,900 ppm, based on the total weight of the positive electrode active material. When the total content of Al and W satisfies the above range, the positive electrode active material can exhibit a high compression density, a low cation mixing ratio, and a low residual lithium content. Accordingly, the energy density of the electrode can be increased, and both the capacity and cycle life characteristics of the battery can be enhanced.

In addition, a ratio (Al/(Al+W)) of the content of Al to the total content of Al and W may be from 0.28 to 0.7, and more specifically from 0.29 to 0.7. When the ratio of the Al content to the total Al and W content satisfies the above range, the aforementioned improvement effects in battery performance can be more desirably achieved.

A cation mixing ratio of nickel cations in a lithium layer of the lithium transition metal oxide may be 2.8% or less. When the cation mixing ratio satisfies the above range, the layered structure of the positive electrode active material can be stabilized, thereby improving the cycle life characteristics of the battery.

The positive electrode active material for a lithium secondary battery may have a residual lithium content of 3,000 ppm or less. When the residual lithium content satisfies the above range, side reactions between lithium by-products and the electrolyte can be reduced, thereby enhancing the safety and cycle life characteristics of the battery.

The positive electrode active material for a lithium secondary battery may have a compression density of 2.2 g/cc or higher. In this specification, the term "compression density" refers to a value calculated by measuring the height of a cylinder after applying a force of 108 N to 10 g of the positive electrode active material placed in a cylinder having a diameter of 19.1 mm.

The positive electrode active material for a lithium secondary battery may have a nickel content of 50 mol% to 70 mol% based on the total moles of transition metals.

The positive electrode active material for a lithium secondary battery may have a cobalt content of 5 mol% to 20 mol% based on the total moles of transition metals.

The positive electrode active material for a lithium secondary battery may have a manganese content of 10 mol% to 40 mol% based on the total moles of transition metals.

The coating content of Al and W described above may be more suitable for achieving improved electrochemical performance characteristics of the battery when the composition of nickel, cobalt, and manganese in the lithium transition metal oxide satisfies the above ranges.

The lithium transition metal oxide described above may be more specifically represented by the following Chemical Formula 1:

$$[\text{Chemical Formula 1}] \qquad Li_a[Ni_xCo_yMnzM_{1w1}]O_2$$

wherein $0.8 \leq a \leq 1.2$, $0.5 \leq x \leq 0.7$, $0.05 \leq y \leq 0.2$, $0.1 \leq z \leq 0.4$, $0 < w_1 \leq 0.1$, and $x + y + z + w_1 = 1$, and $M_1$ is one or more selected from Zr, Y, B, Al, Mg, Ti, Nb, W, Sc, Si, V, Fe, Y, Mo, Ce, Hf, Ta, La, and Sr.

**2. Method for Manufacturing the Positive Electrode Active Material**

According to another embodiment of the present invention, there is provided a method for manufacturing a positive electrode active material for a lithium secondary battery, the method comprising: preparing a nickel-containing transition metal precursor; mixing the transition metal precursor with a lithium raw material, followed by calcination at a temperature of 900°C to 960°C and pulverization to form a single-particle lithium transition metal oxide; and mixing the lithium transition metal oxide with an Al raw material and a W raw material, followed by heat treatment at a temperature of 400°C to 500°C to form a coating layer.

The Al raw material may be $Al_2O_3$, $Al(OH)_3$, $Al_2(SO_3)_3$, or a combination thereof.

The W raw material may be $WO_2$, $WO_3$, $WS_2$, $WS_3$, or a combination thereof.

An amount of the Al raw material and the W raw material to be mixed may be appropriately controlled so that the contents of Al and W in the coating layer of the finally obtained positive electrode active material satisfy the aforementioned range.

The Al raw material and the W raw material may be oxides. When the Al and W raw materials are oxides, the aforementioned improvement effects on the electrochemical performance of the battery can be more desirably achieved.

The heat treatment may be performed for 5 to 8 hours.

The heat treatment may be performed in an air atmosphere.

## 3. Positive Electrode and Lithium Secondary Battery

Another embodiment of the present invention provides a positive electrode for a lithium secondary battery including the aforementioned positive electrode active material.

More specifically, the positive electrode may include a positive electrode current collector and a positive electrode active material layer disposed on the positive electrode current collector, wherein the positive electrode active material layer comprises the aforementioned positive electrode active material.

The positive electrode current collector is not particularly limited as long as it has electrical conductivity without causing chemical changes in the battery. For example, stainless steel, aluminum, nickel, titanium, sintered carbon, or aluminum or stainless steel whose surface is treated with carbon, nickel, titanium, silver, or the like may be used. The positive electrode current collector typically has a thickness of 3 to 500 $\mu$m, and fine irregularities may be formed on the surface thereof to enhance the adhesion of the positive electrode active material. It may be used in various forms, such as a film, sheet, foil, net, porous body, foam, or non-woven fabric.

The positive electrode active material layer may include, in addition to the aforementioned positive electrode active material, a binder and/or a conductive material.

The binder serves to improve adhesion between the positive electrode active material particles and between the positive electrode active material and the positive electrode current collector. Specific examples include polyvinylidene fluoride (PVDF), vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, ethylene-propylene-diene monomer rubber (EPDM rubber), sulfonated EPDM, styrene-butadiene rubber (SBR), fluororubber, or various copolymers thereof. These may be used alone or in combination of two or more, but are not limited thereto. The binder may be included in an amount of 1 to 30 wt% based on the total weight of the positive electrode active material layer.

The conductive material is used to impart electrical conductivity to the electrode and may be any material having electronic conductivity that does not cause chemical changes in the battery. Specific examples include graphite such as natural graphite or artificial graphite; carbon-based materials such as carbon black, acetylene black, ketjen black, channel black, furnace black, lamp black, thermal black, and carbon fibers; metal powders or metal fibers such as copper, nickel, aluminum, or silver; conductive whiskers such as zinc oxide or potassium titanate; conductive metal oxides such as titanium oxide; or conductive polymers such as polyphenylene derivatives. These may be used alone or in combination of two or more, but are not limited thereto. The conductive material may be included in an amount of 1 to 30 wt% based on the total weight of the positive electrode active material layer.

The positive electrode can be manufactured according to a conventional method for manufacturing a positive electrode, except for using the aforementioned positive electrode active material.

Specifically, the positive electrode may be manufactured by applying a composition for forming a positive electrode active material layer-comprising the aforementioned positive electrode active material and, if necessary, a binder, conductive material, and solvent-onto the positive electrode current collector, followed by drying and rolling. In this case, the types and contents of the positive electrode active material, binder, and conductive material are as described above.

The solvent may be any solvent commonly used in the art, such as dimethyl sulfoxide (DMSO), isopropyl alcohol, N-methylpyrrolidone (NMP), acetone, or water, and one or more of these solvents may be used either alone or in combination. The amount of solvent used may be sufficient to dissolve or disperse the positive electrode active material, conductive material, and binder, considering the slurry coating thickness and manufacturing yield, and to provide a viscosity capable of ensuring excellent thickness uniformity during the coating process for electrode fabrication.

Alternatively, the positive electrode may be manufactured by casting the composition for forming the positive electrode active material layer onto a separate support, then peeling off the resulting film from the support, and laminating the film onto the positive electrode current collector.

Another embodiment of the present invention provides a lithium secondary battery including the aforementioned positive electrode for a lithium secondary battery.

More specifically, the lithium secondary battery may include a positive electrode, a negative electrode, a separator, and an electrolyte. The lithium secondary battery may further optionally include a battery case accommodating an electrode assembly of the positive electrode, the negative electrode, and the separator, and a sealing member for sealing the battery case.

The negative electrode may include a negative electrode current collector and a negative electrode active material layer disposed on the negative electrode current collector. The negative electrode current collector is not particularly limited as long as it has high electrical conductivity without causing chemical changes in the battery. Examples include copper, stainless steel, aluminum, nickel, titanium, sintered carbon, copper or stainless steel whose surface is coated with carbon, nickel, titanium, or silver, and aluminum-cadmium alloys. The negative electrode current collector may typically have a thickness of 3 to 500 $\mu$m, and, similar to the positive electrode current collector, fine irregularities may be formed on its surface to enhance adhesion of the negative electrode active material. It may be used in various forms such as a film, sheet, foil, net, porous body, foam, or nonwoven fabric.

The negative electrode active material layer may include a negative electrode active material and may further optionally include a binder and a conductive material. For example, the negative electrode may be manufactured by applying a composition for forming a negative electrode active material layer-comprising a negative electrode active material and optionally a binder and a conductive material-onto the negative electrode current collector, followed by drying. Alternatively, the composition for forming the negative electrode active material layer may be cast on a separate support, and a film obtained by peeling the layer off from the support may be laminated onto the negative electrode current collector.

As the negative electrode active material, a compound capable of reversibly intercalating and deintercalating lithium may be used. Specific examples include carbonaceous materials such as artificial graphite, natural graphite, graphitized carbon fibers, and amorphous carbon; metal compounds capable of forming alloys with lithium, such as Si, Al, Sn, Pb, Zn, Bi, In, Mg, Ga, Cd, silicon alloys, tin alloys, or aluminum alloys; metal oxides capable of lithium doping and dedoping, such as $SiO_\beta$ ($0 < \beta < 2$), $SnO_2$, vanadium oxide, or lithium vanadium oxide; and composites containing both the metal compound and the carbonaceous material, such as Si-C composites or Sn-C composites. One or more of these materials may be used. In addition, a lithium metal thin film may be used as the negative electrode active material. The carbon material may be either low-crystallinity or high-crystallinity carbon. Examples of low-crystallinity carbon include soft carbon and hard carbon, while examples of high-crystallinity carbon include amorphous, flake, plate-like, spherical, or fibrous natural or artificial graphite, Kish graphite, pyrolytic carbon, mesophase pitch-based carbon fibers, mesocarbon microbeads, mesophase pitches, and high-temperature calcined carbons such as petroleum- or coal-tar pitch-derived cokes.

The binder and the conductive material may be the same as those described above for the positive electrode.

The separator separates the positive electrode and the negative electrode and provides a path for lithium-ion migration. Any separator commonly used in lithium secondary batteries may be used without limitation, and it is preferable that the separator has low ionic resistance and excellent electrolyte wettability. Specifically, a porous polymer film such as a polyolefin-based polymer film made of an ethylene homopolymer, propylene homopolymer, ethylene/butene copolymer, ethylene/hexene copolymer, or ethylene/methacrylate copolymer, or a multilayer structure thereof, may be used. In addition, a conventional porous nonwoven fabric, such as one made of high-melting-point glass fibers or polyethylene terephthalate fibers, may also be used. Furthermore, a coated separator containing ceramic components or polymer materials may be used to ensure heat resistance or mechanical strength, and may be used in a single-layer or multilayer structure.

The electrolyte may include an organic liquid electrolyte, inorganic liquid electrolyte, solid polymer electrolyte, gel polymer electrolyte, solid inorganic electrolyte, or molten inorganic electrolyte used for manufacturing lithium secondary batteries, but is not limited thereto.

Specifically, the organic liquid electrolyte may include an organic solvent and a lithium salt. The organic solvent may be any medium capable of allowing the migration of ions involved in the electrochemical reactions of the battery. Examples of the organic solvent include ester-based solvents such as methyl acetate, ethyl acetate, $\gamma$-butyrolactone, and $\varepsilon$-caprolactone; ether-based solvents such as dibutyl ether and tetrahydrofuran; ketone-based solvents such as cyclohexanone; aromatic hydrocarbon-based solvents such as benzene and fluorobenzene; carbonate-based solvents such as dimethyl carbonate (DMC), diethyl carbonate (DEC), methylethyl carbonate (MEC), ethylmethyl carbonate (EMC), ethylene carbonate (EC), and propylene carbonate (PC); alcohol-based solvents such as ethanol and isopropyl alcohol; nitriles such as R-CN (where R is a $C_2$-$C_{20}$ linear, branched, or cyclic hydrocarbon group, which may include a double bond or an ether linkage); amides such as dimethylformamide; dioxolanes such as 1,3-dioxolane; and sulfolanes. Among these, carbonate-based solvents are preferred, and more preferably, a mixture of a cyclic carbonate (e.g., ethylene carbonate or propylene carbonate) having high ionic conductivity and dielectric constant, and a linear carbonate (e.g., ethylmethyl carbonate, dimethyl carbonate, or diethyl carbonate) having low viscosity, may be used. In this case, the cyclic and linear carbonates may be mixed in a volume ratio of about 1:1 to about 1:9 to exhibit excellent electrolyte performance.

The lithium salt may be any compound capable of supplying lithium ions for use in lithium secondary batteries. Specific examples include $LiPF_6$, $LiClO_4$, $LiAsF_6$, $LiBF_4$, $LiSbF_6$, $LiAlO_2$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, LiCl, LiI, or $LiB(C_2O_4)_2$. The concentration of the lithium salt is preferably from 0.1 M to 2.0 M. Within this range, the electrolyte exhibits appropriate conductivity and viscosity, thereby ensuring excellent electrolyte performance and effective movement of lithium ions.

In addition to the electrolyte components, one or more additives may be further included to improve the lifespan characteristics of the battery, suppress capacity degradation, or enhance discharge capacity. Examples of such additives include haloalkylene carbonate compounds such as difluoroethylene carbonate, pyridine, triethyl phosphate, triethanolamine, cyclic ethers, ethylenediamine, n-glyme, hexamethylphosphoramide, nitrobenzene derivatives, sulfur, quinone imine dyes, N-substituted oxazolidinones, N,N-substituted imidazolidines, ethylene glycol dialkyl ethers, ammonium salts, pyrrole, 2-methoxyethanol, or aluminum trichloride. The additive may be included in an amount of 0.1 wt% to 5 wt% based on the total weight of the electrolyte.

As described above, the lithium secondary battery including the positive electrode active material according to the present invention exhibits excellent discharge capacity, output characteristics, and capacity retention, and thus is useful for applications such as portable electronic devices including mobile phones, notebook computers, and digital cameras, as well as in the field of electric vehicles such as hybrid electric vehicles (HEVs).

Accordingly, another embodiment of the present invention provides a battery module including the lithium secondary battery as a unit cell, and a battery pack including the same. The battery module or battery pack may be used as a power source for medium- and large-sized devices such as power tools, electric vehicles (EVs), hybrid electric vehicles (HEVs), plug-in hybrid electric vehicles (PHEVs), or power storage systems.

Hereinafter, embodiments of the present invention will be described in more detail through examples. However, the following examples are merely preferred embodiments of the present invention and are not intended to limit the present invention thereto.

### Example 1

### (1) Preparation of Positive Electrode Active Material

*(Formation of Lithium Transition Metal Oxide)*

A precursor having a composition of $Ni_{0.6}Co_{0.1}Mn_{0.3}(OH)_2$ was prepared. $LiOH \cdot H_2O$ and the precursor were mechanically mixed in a mixer to form a mixture such that the molar ratio (Li/M) of lithium to the transition metals in the precursor was 1.05. Thereafter, the mixture was calcined at 940°C for 15 hours in an oxygen atmosphere, followed by natural cooling. The calcined product was pulverized to obtain a single-particle lithium transition metal oxide.

*(Formation of Coating Layer)*

For the single-particle lithium transition metal oxide obtained as described above, $Al_2O_3$ and $WO_3$ were added in amounts corresponding to 700 ppm of Al and 1,400 ppm of W, respectively. The mixture was mechanically mixed in a mixer and subsequently heat-treated at 460°C for 6 hours in an air atmosphere, thereby producing the lithium transition metal oxide according to Example 1.

### (2) Fabrication of Lithium Secondary Battery

A slurry for electrode fabrication was prepared by mixing the obtained positive electrode active material, conductive material (carbon black, Denka Black), and binder (PVDF, KF9700) in a weight ratio of 96.5:2.0:1.5. N-methyl-2-pyrrolidone (NMP) was added to adjust the viscosity such that the solid content was approximately 60%. The prepared slurry was coated onto a 20-$\mu$m-thick aluminum foil using a doctor blade, followed by drying and rolling. The electrode loading amount was 16.0 mg/cm$^2$, and the rolling density (25°C, 20 kN) was 3.5 g/cm$^3$.

As the electrolyte, a 1 M $LiPF_6$ solution in a mixed solvent of EC:DMC:DEC = 1:2:1 (vol%) was used, to which 2.0 vol% of VC (vinylene carbonate) was added. A coin cell was fabricated using a polyethylene separator and a lithium metal negative electrode (400 $\mu$m, NEBA Metal).

### Other Examples and Comparative Examples

Except for varying the addition amounts of Al and W during the coating layer formation, the positive electrode active materials and lithium secondary batteries were prepared in the same manner as in Example 1, as shown in Tables 1 and 2 below.

**Experimental Example 1: Evaluation of Active Material Properties According to Variation in Total Al and W Content**

(1) **Compression Density (g/cc):**

10 g of the positive electrode active material was placed in a cylinder having a diameter of 19.1 mm, and a pressure of 108 N was applied. The height of the cylinder was then measured to calculate the compression density.

(2) **Cation Mixing Ratio (%):**

For the positive electrode active material, the ratio of the intensity of the (003) peak to that of the (104) peak in the XRD data was measured to determine the cation mixing ratio.

(3) **Residual Lithium Content:**

Distilled water was added to the positive electrode active material, and the mixture was stirred to extract residual lithium. The slurry was filtered to separate the powder from the extracted solution, and the residual lithium content was measured by neutralization titration of the filtrate using a Metrohm potentiometric titrator.

[Table 1]

|  | Al Coating Content (ppm) | W Coating Content (ppm) | Total Al + W Coating Content (ppm) | Press density (g/cc) | Cation mixing (%) | Residual Lithium (ppm) |
|---|---|---|---|---|---|---|
| Comparative example 1 | 700 | 700 | 1400 | 2.081 | 2.9 | 2600 |
| Example 1 | 700 | 1400 | 2100 | 2.226 | 2.6 | 2500 |
| Example 2 | 1600 | 1600 | 3200 | 2.236 | 2.6 | 2800 |
| Example 3 | 1400 | 3200 | 4600 | 2.240 | 2.6 | 2800 |
| Example 4 | 1700 | 4200 | 5900 | 2.248 | 2.5 | 2700 |
| Comparative example 2 | 2100 | 4200 | 6300 | 2.198 | 2.5 | 3200 |

Referring to Table 1, in the cases of Examples 1 to 4, where the total content of the coating elements Al and W was appropriately adjusted within the range according to the present invention, the positive electrode active materials exhibited high compression density, indicating that an improvement in electrode energy density can be expected. In addition, it was confirmed that these examples showed low cation mixing ratios and low residual lithium contents.
In contrast, in Comparative Example 1, where the total content of Al and W was too low, the cation mixing ratio was found to be excessively high.
Meanwhile, in Comparative Example 2, where the total content of Al and W was too high, the residual lithium content was found to be excessively large.

**Experimental Example 2: Evaluation of Electrochemical Properties According to Al/(Al+W) Coating Ratio**

(1) **Evaluation of Initial Discharge Capacity and Initial Efficiency**

Coin-type half-cells prepared as described above were aged at room temperature (25°C) for 10 hours and then subjected to charge/discharge testing. The capacity was evaluated based on a reference capacity of 200 mAh/g, and the charge/discharge conditions were set to CC/CV 2.5-4.4 V with a 1/20C cut-off. The initial capacity was measured under 0.1C charge / 0.1C discharge conditions.

(2) **Evaluation of High-Temperature Cycle Life Characteristics (45°C, 50 cycles, %)**

The prepared coin-type half-cells were subjected to charge/discharge cycling between 2.5 V and 4.4 V at 45°C under the conditions of 0.5C charge and 1C discharge (based on a reference capacity of 200 mAh/g). After 50 charge/discharge cycles, the capacity retention rate at the 50th cycle was measured relative to that of the first cycle.

(3) **Evaluation of High-Temperature Resistance Characteristics (45°C, 50 cycles, %)**

An increase in resistance was measured according to Equation (1) below, comparing the resistance at 60 seconds during discharge in the 50th cycle with that in the first cycle.

**[Equation 1]**

$$[\{(\text{Resistance at } 50^{\text{th}} \text{ cycle}) - (\text{Resistance at } 1^{\text{st}} \text{ cycle})\}/(\text{Resistance at } 1^{\text{st}} \text{ cycle})] \times 100 (\%)$$

[Table 2]

| | Total Coating Amount (ppm) | Al/(Al+W) Ratio | 0.1C/0.1C Discharge Capacity (mAh/g) | 0.1C/0.1C Efficiency (%) | 45°C 0.5C/1C 50-Cycle High-Temperature Capacity Retention (%) | 45°C 0.5C/1C Resistance Increase After 50 Cycles (%) |
|---|---|---|---|---|---|---|
| Comparative example 3 | Al 0 W 2800 | 0 | 195.6 | 90.6 | 92.5 | 131.3 |
| Example 3 | Al 1400 W 3200 | 0.3 | 195.7 | 90.9 | 94.8 | 75.5 |
| Example 4 | Al 1700 W 4200 | 0.29 | 195.4 | 91.0 | 95.7 | 64.6 |
| Example 2 | Al 1600 W 1600 | 0.5 | 195.6 | 91.0 | 95.8 | 67.8 |
| Example 5 | Al 2100 W 1400 | 0.6 | 195.5 | 91.0 | 95.5 | 68.7 |
| Example 6 | Al 2100 W 900 | 0.7 | 195.2 | 90.8 | 95.4 | 73.0 |
| Comparative example 4 | Al 1400 W 0 | 1 | 194.2 | 90.3 | 95.5 | 80.2 |

Referring to Table 2, in the cases of Examples 2 to 6, where the Al/(Al+W) ratio was appropriately adjusted within the range of the present invention, the battery exhibited excellent overall electrochemical performance, including discharge capacity, initial efficiency, high-temperature cycle life, and resistance characteristics.

In contrast, in Comparative Example 3, where the Al/(Al+W) ratio was too low, it was confirmed that the high-temperature cycle life characteristics were somewhat degraded, and the high-temperature resistance characteristics were significantly deteriorated.

Furthermore, in Comparative Example 4, where the Al/(Al+W) ratio was excessively high, deterioration in capacity and high-temperature resistance characteristics was observed.

The above description illustrates preferred embodiments of the present invention; however, the present invention is not limited thereto, and various modifications and changes may be made within the scope of the appended claims, the detailed description of the invention, and the accompanying drawings.

Accordingly, the true scope of the present invention shall be defined by the appended claims and their equivalents.

**Claims**

1. A positive electrode active material for a lithium secondary battery, which is in a single particle form and comprises a nickel-containing lithium transition metal oxide and a coating layer containing Al and W disposed on the surface of the lithium transition metal oxide, wherein a total content of the Al and W is from 2,000 ppm to 6,000 ppm based on the total weight of the positive electrode active material.

2. The positive electrode active material for a lithium secondary battery of claim 1, wherein a ratio (Al/(Al+W)) of the content of Al to the total content of Al and W is from 0.28 to 0.7.

3. The positive electrode active material for a lithium secondary battery of claim 1, wherein a nickel content in the lithium transition metal oxide is from 50 mol% to 70 mol% based on the total moles of transition metals.

4. The positive electrode active material for a lithium secondary battery of claim 1, wherein a cobalt content in the lithium transition metal oxide is from 5 mol% to 20 mol% based on the total moles of transition metals.

5. The positive electrode active material for a lithium secondary battery of claim 1, wherein a manganese content in the lithium transition metal oxide is from 10 mol% to 40 mol% based on the total moles of transition metals.

6. The positive electrode active material for a lithium secondary battery of claim 1, wherein a cation mixing ratio of nickel cations in a lithium layer of the lithium transition metal oxide is 2.8% or less.

7. The positive electrode active material for a lithium secondary battery of claim 1, wherein a content of residual lithium is 3,000 ppm or less.

8. The positive electrode active material for a lithium secondary battery of claim 1, wherein a compression density is 2.2 g/cc or higher.

9. The positive electrode active material for a lithium secondary battery of claim 1, wherein the lithium transition metal oxide is represented by the following Chemical Formula 1:

   **[Chemical Formula 1]**     $Li_a[Ni_xCo_\gamma MnzM_{1w1}]O_2$

   wherein $0.8 \leq a \leq 1.2$, $0.5 \leq x \leq 0.7$, $0.05 \leq y \leq 0.2$, $0.1 \leq z \leq 0.4$, $0 < w_1 \leq 0.1$, and $x + y + z + w_1 = 1$, and $M_1$ is one or more selected from Zr, Y, B, Al, Mg, Ti, Nb, W, Sc, Si, V, Fe, Y, Mo, Ce, Hf, Ta, La, and Sr.

10. A method for manufacturing a positive electrode active material for a lithium secondary battery, comprising:

    preparing a nickel-containing transition metal precursor;
    mixing the transition metal precursor and a lithium raw material, followed by calcination at a temperature of 900°C to 960°C and pulverization to form a single-particle lithium transition metal oxide; and
    mixing the lithium transition metal oxide with an Al raw material and a W raw material, followed by heat treatment at a temperature of 400°C to 500°C to form a coating layer.

11. The method for manufacturing a positive electrode active material for a lithium secondary battery of claim 10, wherein the Al raw material is $Al_2O_3$, $Al(OH)_3$, $Al_2(SO_3)_3$, or a combination thereof.

12. The method for manufacturing a positive electrode active material for a lithium secondary battery of claim 10, wherein the W raw material is $WO_2$, $WO_3$, $WS_2$, $WS_3$, or a combination thereof.

13. The method for manufacturing a positive electrode active material for a lithium secondary battery of claim 10, wherein the Al raw material and the W raw material are oxides.

14. The method for manufacturing a positive electrode active material for a lithium secondary battery of claim 10, wherein the heat treatment is performed for 5 to 8 hours.

15. The method for manufacturing a positive electrode active material for a lithium secondary battery of claim 10, wherein the heat treatment is performed in an air atmosphere.

16. A positive electrode for a lithium secondary battery comprising the positive electrode active material of any one of claims 1 to 9.

17. A lithium secondary battery comprising the positive electrode of claim 16.

## INTERNATIONAL SEARCH REPORT

| International application No. |
|---|
| **PCT/KR2024/007029** |

**A. CLASSIFICATION OF SUBJECT MATTER**

**H01M 4/36**(2006.01)i; **H01M 4/525**(2010.01)i; **C01G 53/00**(2006.01)i; **H01M 10/052**(2010.01)i; **C30B 29/22**(2006.01)i; **H01M 4/02**(2006.01)i

According to International Patent Classification (IPC) or to both national classification and IPC

**B. FIELDS SEARCHED**

Minimum documentation searched (classification system followed by classification symbols)

H01M 4/36(2006.01); C01B 32/991(2017.01); H01M 10/052(2010.01); H01M 2/10(2006.01); H01M 4/505(2010.01); H01M 4/525(2010.01); H01M 4/62(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 리튬 이차전지(lithium secondary battery), 양극 활물질(cathode material), 리튬 전이금속 산화물(lithium transition metal oxide), 알루미늄(aluminium), 텅스텐(tungsten), 코팅층(coating layer), 함량(content), 단입자(single particle)

**C. DOCUMENTS CONSIDERED TO BE RELEVANT**

| Category* | Citation of document, with indication, where appropriate, of the relevant passages | Relevant to claim No. |
|---|---|---|
| X | CN 115863602 A (BASF SHANSHAN BATTERY MATERIALS CO., LTD.) 28 March 2023 (2023-03-28) See claims 1, 5, 6, 9 and 10-12; and paragraph [0021]. | 1-9,16-17 |
| Y | | 10-15 |
| Y | KR 10-2020-0073552 A (COSMO AM&T CO., LTD.) 24 June 2020 (2020-06-24) See claim 5; and paragraph [0093]. | 10-15 |
| A | KR 10-2019-0117049 A (LG CHEM, LTD.) 16 October 2019 (2019-10-16) See claims 1-4 and 13-14. | 1-17 |
| A | JP 2014-143032 A (HITACHI LTD.) 07 August 2014 (2014-08-07) See claims 1, 9, 11 and 21-22. | 1-17 |

☑ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 September 2024** | **04 September 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/007029** |

**C. DOCUMENTS CONSIDERED TO BE RELEVANT**

| Category* | Citation of document, with indication, where appropriate, of the relevant passages | Relevant to claim No. |
|---|---|---|
| A | WO 2017-069410 A1 (LG CHEM, LTD.) 27 April 2017 (2017-04-27)<br>　　　See claims 1-2, 5-6 and 21-22. | 1-17 |
| A | CN 114243014 A (GUANGDONG BONGPU CYCLE SCIENCE AND TECHNOLOGY CO. et al.) 25 March 2022 (2022-03-25)<br>　　　See claims 1-10. | 1-17 |

Form PCT/ISA/210 (second sheet) (July 2022)

**INTERNATIONAL SEARCH REPORT**
Information on patent family members

International application No.

**PCT/KR2024/007029**

| Patent document cited in search report | | | Publication date (day/month/year) | Patent family member(s) | | | Publication date (day/month/year) |
|---|---|---|---|---|---|---|---|
| CN | 115863602 | A | 28 March 2023 | None | | | |
| KR | 10-2020-0073552 | A | 24 June 2020 | KR | 10-2162461 | B1 | 06 October 2020 |
| KR | 10-2019-0117049 | A | 16 October 2019 | KR | 10-2204938 | B1 | 19 January 2021 |
| JP | 2014-143032 | A | 07 August 2014 | None | | | |
| WO | 2017-069410 | A1 | 27 April 2017 | CN | 107925065 | A | 17 April 2018 |
| | | | | CN | 107925065 | B | 01 June 2021 |
| | | | | EP | 3316357 | A1 | 02 May 2018 |
| | | | | EP | 3316357 | B1 | 29 July 2020 |
| | | | | JP | 2018-523895 | A | 23 August 2018 |
| | | | | JP | 6662531 | B2 | 11 March 2020 |
| | | | | KR | 10-1982790 | B1 | 27 May 2019 |
| | | | | KR | 10-2017-0046066 | A | 28 April 2017 |
| | | | | US | 10741872 | B2 | 11 August 2020 |
| | | | | US | 2018-0241073 | A1 | 23 August 2018 |
| CN | 114243014 | A | 25 March 2022 | WO | 2023-071409 | A1 | 04 May 2023 |

Form PCT/ISA/210 (patent family annex) (July 2022)